# EUROPEAN PATENT APPLICATION

(11) **EP 3 393 217 A1**
(43) Date of publication of application: **24.10.2018**
(21) Application number: 16875225.1
(22) Date of filing: 11.10.2016
(51) Int. Cl.: H05K 3/10, H05K 3/12

(54) **WIRING BOARD AND METHOD FOR PRODUCING WIRING BOARD**

(30) Priority: 17.12.2015 JP 2015246158
(71) Applicant: Fujikura Ltd., Tokyo 135-8512 (JP)
(72) Inventor: KAIZU, Masahiro, Tokyo 135-8512 (JP)
(74) Representative: Ter Meer Steinmeister & Partner
(86) International application number: PCT/JP2016/080107
(87) International publication number: WO 2017/104240

(57) **Abstract**

A wiring board 1 includes: a support body 10 which has a plurality of openings 13 passing from an upper surface 101 to a lower surface 102; and a conductor 20 which is supported by the support body 10. The conductor 20 includes a first outer layer 21 which is formed on the upper surface 101 of the support 10, a second outer layer 22 which is formed on the lower surface 102 of the support 10 and has substantially the same shape as the first outer layer 21, and an inner layer 23 which is formed inside the support body 10 and connects the first outer layer 21 and the second outer layer 22, and the inner layer 23 has a frame shape which is along an outer edge of the first outer layer and along the second outer layer 22.

## Description

### TECHNICAL FIELD

The present invention relates to a wiring board and a method of manufacturing the wiring board.

For designated countries which are permitted to be incorporated by reference in the literature, the content described in Japanese Patent Application No. 2015-246158 filed in Japan on December 17, 2015 is incorporated herein by reference as a part of the description of the specification of the present application.

### BACKGROUND ART

There is disclosed a method of forming a conductive thin film on a board by forming a thin film by depositing a dispersed solution containing a metal oxide and a reducing agent on the board and reducing and sintering a metal oxide by exposing the thin film to pulsed electromagnetic radiation (for example, see Patent Document 1).

### CITATION LIST

### PATENT DOCUMENT

Patent Document 1: JP 2012-505966 T

### SUMMARY OF THE INVENTION

### PROBLEM TO BE SOLVED BY THE INVENTION

In some cases, depending on intended use, a wiring board may be configured in a so-called double-sided exposed structure (a structure where a conductive thin film formed on one surface of the board can be electrically connected from the other surface of a board; a double access structure). In a wiring board manufactured by a manufacturing method such as a subtractive method in the related art, double-sided exposed structure is secured by forming a through hole in a board and exposing a conductive thin film to a back surface side through the through hole.

However, in the wiring board manufactured by the photo-sintering process as described above, an unreduced/unsintered metal oxide remains as an insulator at the bottom of the conductive thin film. Therefore, even if the through hole is formed in the board, there is a problem in that electrical connection to the conductive thin film from the back surface side of the board cannot be secured and the double-sided exposed structure cannot be formed.

The invention is to provide a wiring board capable of securing a function equivalent to a double-sided exposed structure even in a case where a photo-sintering process is used and a method of manufacturing the wiring board.

### MEANS FOR SOLVING PROBLEM

[1] A wiring board according to the invention includes a support body which has a plurality of openings passing from one surface to other surface, and a conductor which is supported by the support body, wherein the conductor includes a first outer layer which is formed on one side of the support body, a second outer layer which is formed on the other surface of the support body and has substantially the same shape as the first outer layer, and an inner layer which is formed inside the support body and connects the first outer layer and the second outer layer, and the inner layer has at least a frame shape which is along an outer edge of the first outer layer and along an outer edge of the second outer layer.
[2] In the above invention, the wiring board may further include an insulator which is provided inside the frame-like inner layer and is made of a metal oxide.
[3] In the above invention, the inner layer may have substantially the same solid shape as the first outer layer.
[4] In the above invention, the support body may include a nonwoven fabric made of at least one of a glass fiber and a resin fiber.
[5] In the above invention, the support body may be made of a plurality of types of substrates stacked on each other, and the plurality of types of the substrates may include a plurality of types of nonwoven fabrics which are made of different types of fibers.
[6] In the above invention, the wiring board may further include an insulating layer which covers the conductor and infiltrates into the support body, wherein the insulating layer includes: a first window which exposes a portion of the first outer layer to an outside; and a second window which exposes a portion of the second outer layer to an outside.
[7] A method of manufacturing a wiring board according to the invention includes: a first step of supporting a precursor including at least one of metal particles and metal oxide particles on a support body; and a second step of irradiating the precursor with a pulsed electromagnetic wave to form a conductor, wherein the support body has a plurality of openings passing from one surface to other surface, and the first step includes forming the precursor on the support body so that the precursor passes through the openings from one side to the other side of the support body.
[8] In the above invention, the first step may include applying a dispersed solution including at least one of metal particles and a metal oxide to only one surface of the support body.
[9] In the above invention, the first step may include applying a dispersed solution including at least one of metal particles and a metal oxide to both surfaces of the support body.
[10] In the above invention, the method of manufacturing the wiring board may further include a third step of compressing the conductor.
[11] In the above invention, the method of manufacturing a wiring board may further include a fourth step of forming an insulating layer covering the conductor and infiltrating into the support body.

### EFFECT OF THE INVENTION

In the invention, a support body has a plurality of openings passing from one side to the other side, and an inner layer formed inside the support body connects a first outer layer and a second outer layer. Therefore, even in a case where a photo-sintering process is used, it is possible to form a wiring board having the same function as a double-sided exposed structure.

In the invention, a precursor is formed on the support body so that the precursor to constitute a conductor passes from one surface to the other surface of the support body through a plurality of openings. Therefore, it is possible to form a wiring board having the same function as a double-sided exposed structure by using a photo-sintering process.

### BRIEF DESCRIPTION OF DRAWINGS

Fig. 1 is a perspective view illustrating a wiring board in an embodiment of the invention;
Fig. 2 is a cross-sectional view taken along line II-II of Fig. 1;
Fig. 3 is a partially enlarged plan view of a wiring board in the embodiment of the invention;
Fig. 4 is a cross-sectional view taken along line IV-IV of Fig. 2;
Fig. 5 is a cross-sectional view illustrating a modified example of the wiring board in the embodiment of the invention;
Fig. 6 is a cross-sectional view taken along line VI-VI of Fig. 5;
Fig. 7 is a flowchart illustrating a method of manufacturing a wiring board in an embodiment of the invention;
Fig. 8(a) is a cross-sectional view in step S10 of Fig. 7, Figs. 8(b) and 8(c) are cross-sectional views in step S20 of Fig. 7, and Fig. 8(d) is a cross-sectional view in step S30 of Fig. 7;
Fig. 9 is a partial enlarged plan view of a support body used in an embodiment of the invention;
Fig. 10 is a cross-sectional view illustrating a modified example of the support body used in the embodiment of the invention;
Figs. 11(a) to 11(f) are cross-sectional views of a modified example of steps S10 to S30 in Fig. 7;
Fig. 12(a) is a cross-sectional view in step S40 of Fig. 7, and Fig. 12(b) is a cross-sectional view in step S50 of Fig. 7; and
Figs. 13(a) and 13(b) are cross-sectional views in step S60 of Fig. 7, and Fig. 13(c) is a cross-sectional view in step S70 of Fig. 7.

### MODE(S) FOR CARRYING OUT THE INVENTION

Hereinafter, embodiments will be described with reference to the drawings.

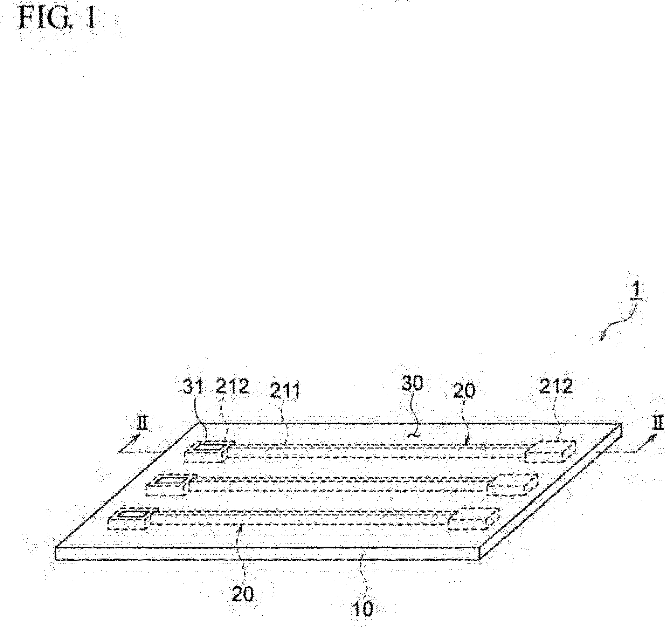

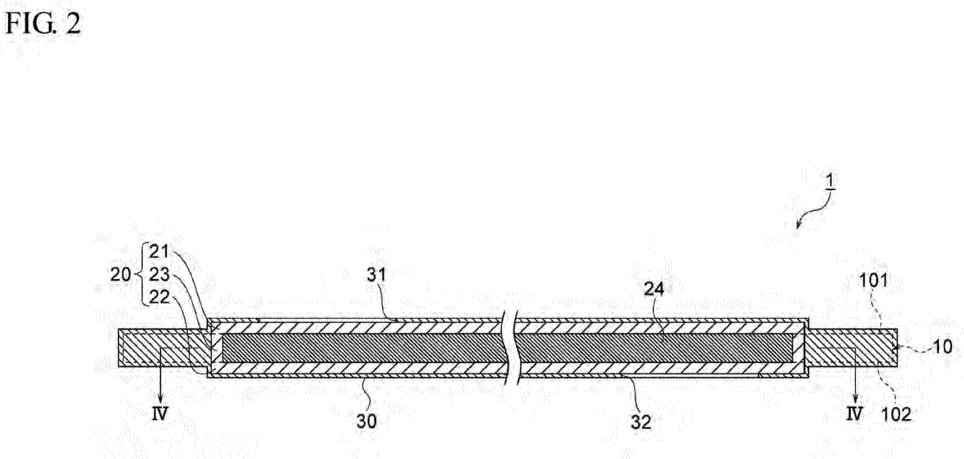

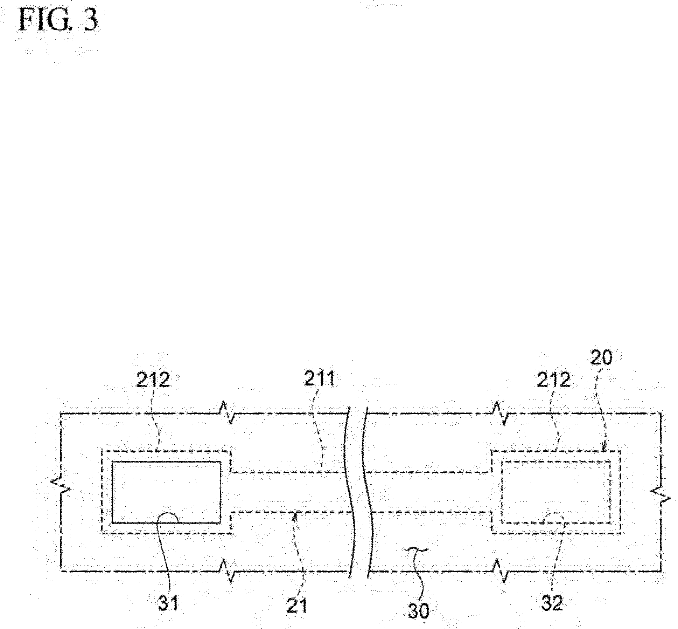

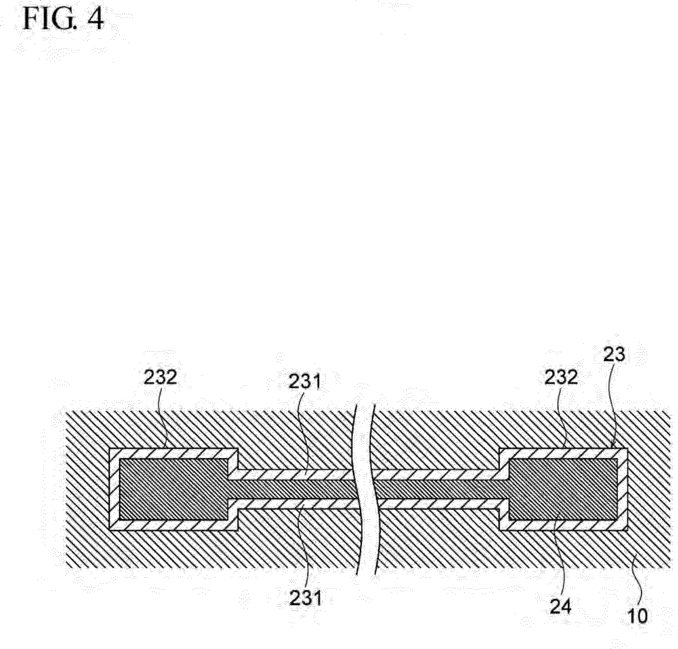

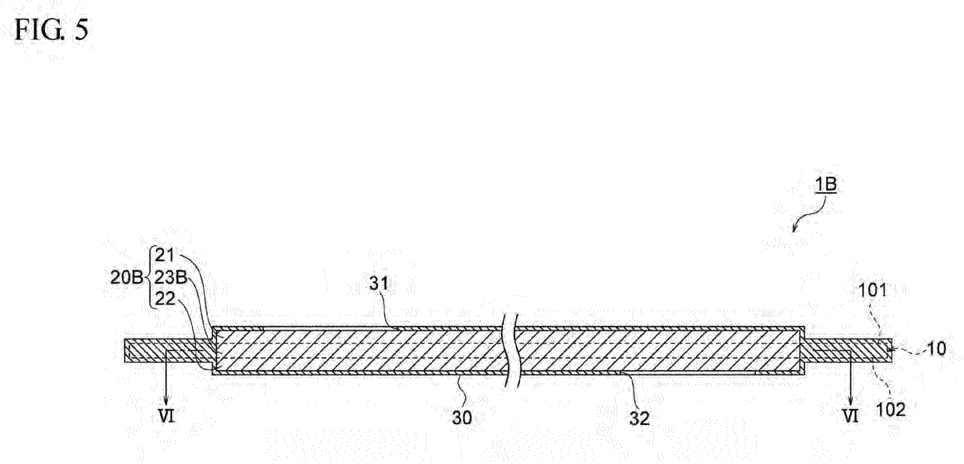

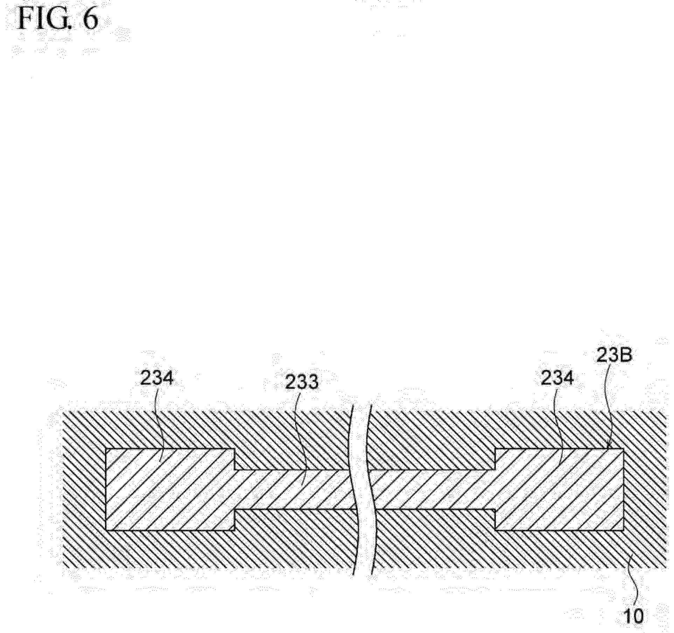

Figs. 1 and 2 are a perspective view and a cross-sectional view of a wiring board in an embodiment, Fig. 3 is a partial enlarged plan view of the wiring board in this embodiment, Fig. 4 is a cross sectional view taken along line IV-IV of Fig. 2, Fig. 5 is a cross-sectional view illustrating a modified example of the wiring board in this embodiment, and Fig. 6 is a sectional view taken along line VI-VI of Fig. 5.

As illustrated in Figs. 1 and 2, the wiring board 1 in this embodiment includes a support body 10, a conductor 20, and an insulating layer 30. Applications of the wiring board 1 include antennas mounted on windows of cars and inner surfaces of bumpers of cars. Applications of the wiring board in the invention are not particularly limited to the above-mentioned ones. For example, the wiring board according to the invention may be used as an inner layer of a multilayer printed wiring board. Depending on the application of the wiring board 1, the wiring board 1 may not have the insulating layer 30.

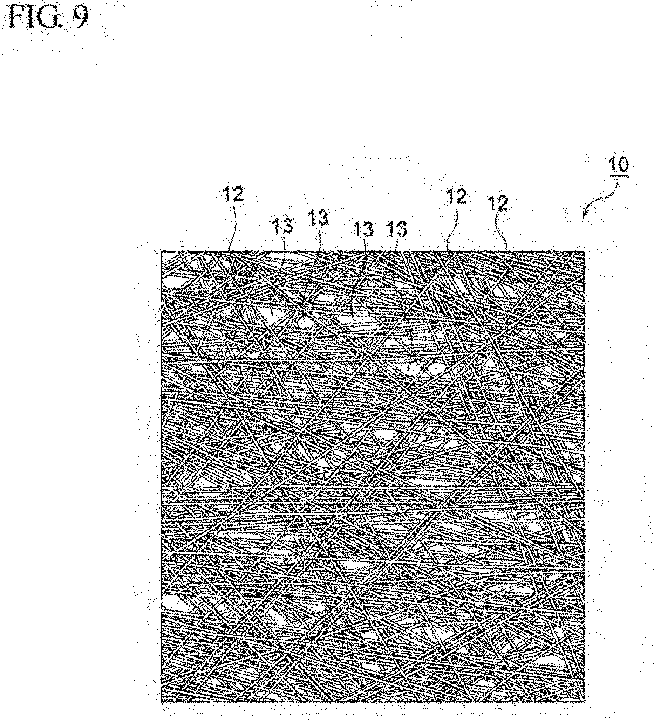

The support body 10 is formed of a nonwoven fabric made of a glass fiber and has electrical insulation properties. The support body 10 has a large number of openings 13 (refer to Fig. 9) passing from an upper surface 101 to a lower surface 102. The structure of the support body 10 will be described in detail later, together with the description of a method of manufacturing the wiring board 1 in this embodiment.

The conductor 20 is used, for example, as a conductor portion of the wiring board 1 such as a wiring pattern, a land, and a pad. The conductor 20 is made of a metal material such as copper (Cu), silver (Ag), molybdenum (Mo), or tungsten (W) and has conductivity. The conductor 20 is formed by drying and sintering a metal oxide ink 41 impregnated into the support body 10 as described in detail later. A conductive metal thin film may be additionally formed on a surface of the conductor 20 by electrolytic plating treatment or electroless plating treatment.

As illustrated in Fig. 2, the conductor 20 in this embodiment includes a first outer layer 21, a second outer layer 22, and an inner layer 23.

The first outer layer 21 is formed on the upper surface 101 of the support body 10. As illustrated in Fig. 3, in a transparent plan view (a plan view in the case where the wiring board 1 is transparently viewed from above or below (in a direction normal to the wiring board 1)), the first outer layer 21 has a planar shape which includes a linear portion 211 and enlarged portions 212 connected to respective ends of the linear portion 211. The planar shape of the first outer layer 21 is not particularly limited to the above-mentioned shape, and arbitrary shapes can be adopted.

The second outer layer 22 is formed on the lower surface 102 of the support body 10. The second outer layer 22 has a planar shape substantially the same as the planar shape of the first outer layer 21 in a transparent plan view and has a linear portion and a pair of enlarged portions connected to respective ends of the linear portion.

The inner layer 23 is formed inside the support body 10 by a metal oxide ink 41 (described later) with which the support body 10 is impregnated. The inner layer 23 has a frame-like planar shape along the outer edge of the first outer layer 21 and along the outer edge of the second outer layer 22 in a transparent plan view, and the first outer layer 21 and the second outer layer 22 are connected through the inner layer 23 formed in the opening 13. More specifically, as illustrated in Fig. 4, the inner layer 23 has a frame-like planar shape configured with a pair of long side portions 231 and rectangular portions 232 that are continuous with respective ends of the long side portions 231. The long side portion 231 corresponds to the side of the linear portion 211 of the first outer layer 21, and the rectangular portion 232 corresponds to the enlarged portion 212 of the first outer layer 21.

In this embodiment, the inside of the frame-like inner layer 23 is filled with an insulator 24. The insulator 24 is made of a metal oxide such as a copper oxide (Cu₂O, CuO), a silver oxide (Ag₂O), a molybdenum oxide (MoO₂, MoO₃), or a tungsten oxide (WO₂, WO₃).

As illustrated in Figs. 5 and 6, the inner layer 23B of the conductor 20B may have substantially the same solid planar shape as that of the first outer layer 21 in a transparent plan view and may have a linear portion 233 and a pair of enlarged portions 234. In this case, the wiring board 1B does not have the insulator 24.

The insulating layer 30 is made of, for example, a resin material and has electrical insulation properties. The insulating layer 30 is formed by impregnating the support body 10 on which the conductor 20 is formed with the liquid resin and curing the liquid resin, as described in detail later. Therefore, the insulating layer 30 covers the conductor 20 and infiltrates into the support body 10. Due to this insulating layer 30, it is possible to secure the mechanical strength and electrical insulation property of the wiring board 1 and to protect the conductor 20.

A first window 31 is formed on one surface of the insulating layer 30, and a second window 32 is formed on the other surface of the insulating layer 30. The first window 31 exposes one enlarged portion 212 of the first outer layer 21 of the conductor 20 upward. On the other hand, the second window 32 exposes the other enlarged portion of the second outer layer 22 of the conductor 20 downward. Therefore, it is possible to electrically connect from both upper and lower sides to the conductor 20 of the wiring board 1.

As described above, in this embodiment, the support body 10 has a plurality of openings 13 passing from the upper surface 101 to the lower surface 102, and the conductor 20 passes the support body 10 while keeping the same planar shape. Therefore, even in a case where a photo-sintering process is used, it is possible to form the wiring board 1 having the same function as the wiring board having the double-sided exposed structure.

For example, in a vehicle-mounted antenna, a conductor pattern having a thickness of about 50 to 100 µm is required for stabilizing reception gain characteristic, and the vehicle-mounted antenna is typically manufactured by using a copper foil having a thickness of 50 µm or more. On the other hand, in the wiring board 1 of this embodiment, it is possible to secure a thickness of 50 µm or more by the total thickness of the pair of outer layers 21 and 22, and to allows the outer layers 21 and 22 to be electrically in contact with each other in a wide region through the inner layer 23. Therefore, it is possible to manufacture the vehicle-mounted antenna on the wiring board 1 by using the silver wiring, and the cost can be reduced.

By selecting a resin material constituting the insulating layer 30, it possible to easily achieve matching of characteristic values (for example, thermal dimension change, adhesion stability, and the like) of the wiring board 1 with surrounding vehicle-body materials when the wiring board 1 is mounted on the vehicle.

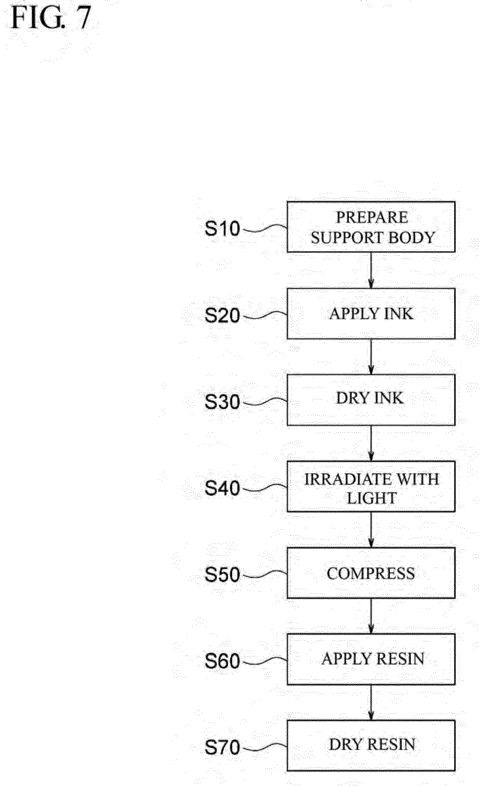

Next, a method of manufacturing the wiring board 1 in this embodiment will be described with reference to Figs. 7 to 13(c).

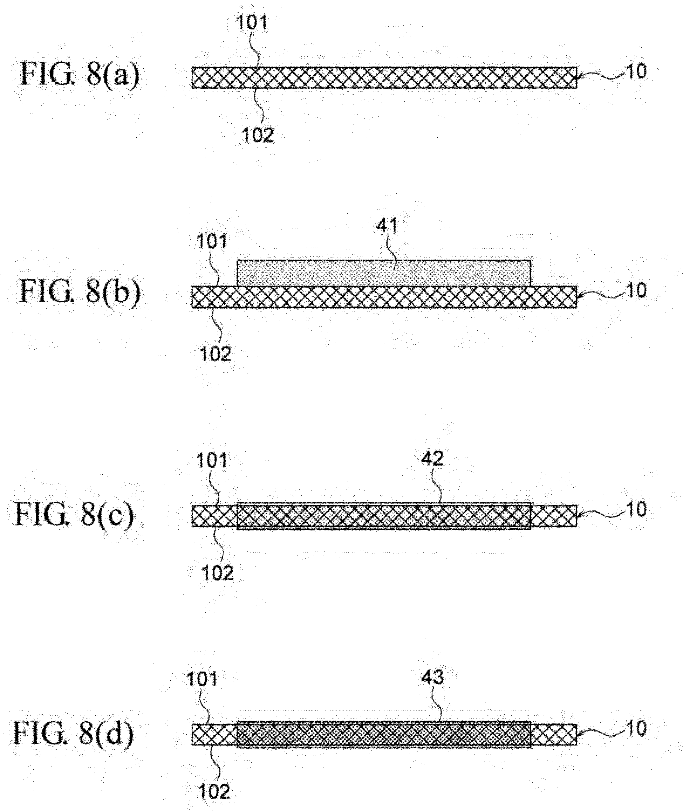

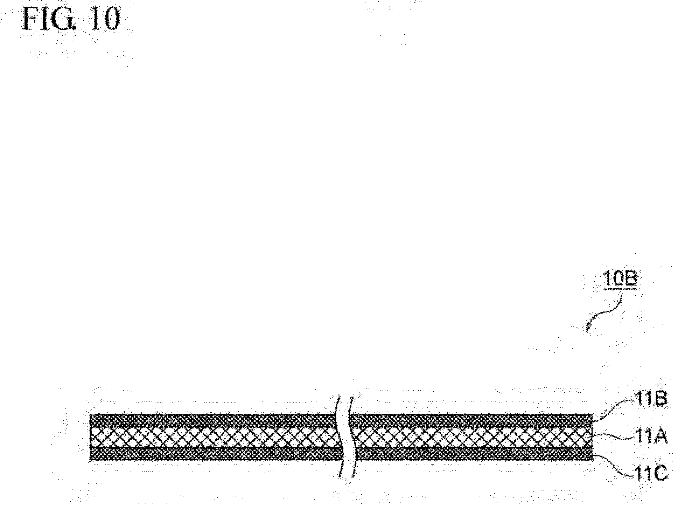

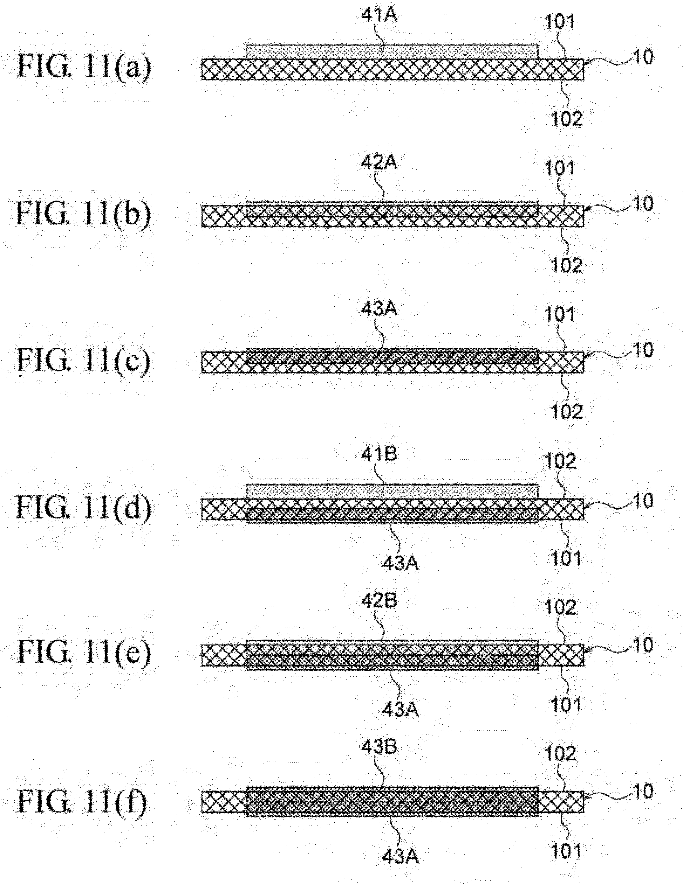

Fig. 7 is a flowchart illustrating a method of manufacturing a wiring board in this embodiment, Figs. 8(a) to 8(d) are cross-sectional views in steps S10 to S30 of Fig. 7, Fig. 9 is a partial enlarged view of a support body used in this embodiment, Fig. 10 is a cross-sectional view illustrating a modified example of the support body used in this embodiment, Figs. 11(a) to 11(f) are cross-sectional views of a modified example of steps S10 to S30 of Fig. 7, and Fig. 12(a) to Fig. 13(c) are cross-sectional views in steps S40 to S70 of Fig. 7.

The method of manufacturing the wiring board 1 in this embodiment is a method of forming the wiring board 1 having the same function as the double-sided exposed structure by using a photo-sintering process.

First, in step S10 of Fig. 7, the support body 10 is prepared as illustrated in Fig. 8(a). As illustrated in Fig. 9, the support body 10 is made of a sheet-like nonwoven fabric formed by bonding a plurality of randomly aligned fibers 12 to each other. The fibers 12 in this embodiment are glass fibers having a diameter of about 5 to 15 µm and have heat resistance of about 800°C. As a binder for bonding the fibers 12, a resin material containing an acrylic resin or an epoxy resin as a main constituent may be exemplified. This binder bonds the fibers 12 to each other at intersection points. Therefore, voids are formed between the fibers 12, and a large number of openings 13 linearly passing from the upper surface 101 to the lower surface 102 are formed in the support body 10. The support body 10 has a thickness of about 50 to 100 µm and a porosity of about 75 to 90%. The thickness of the support body 10 is not particularly limited, and for example, the support body may have a thickness of 30 µm or less. The thickness and porosity of the support body 10 influence the performance of infiltration of the metal oxide ink 41 into the support body 10 in step S20 of Fig. 7 to be described later and the performance of infiltration of pulsed light into the support body 10 in step S40 of Fig. 7 to be described later.

The fibers constituting the support body 10 are not particularly limited to glass fibers as long as the fibers have heat resistance to the extent that the fibers are not melted in the photo-sintering process (step S40 in Fig. 7) described later. For example, as the fibers constituting the support body 10, resin fibers such as vinylon fiber and aramid fiber may be used. In order to ensure the affinity with the metal oxide ink 41 (described later) and the strength of the support body 10, chemical treatment or physical treatment may be performed on the surface of the fiber 11.

In the above-described example, the support body 10 is configured with a single sheet of a substrate made of nonwoven fabric, but the configuration of the support body is not particularly limited thereto, and a support body may be configured by staking a plurality of nonwoven fabrics. In this case, the types of fibers constituting a plurality of nonwoven fabrics may be different from each other, the diameters of fibers constituting a plurality of nonwoven fabrics may be different from each other, or the density of fibers constituting a plurality of nonwoven fabrics may be different from each other.

For example, as illustrated in Fig. 10, three substrates 11A to 11C may be stacked on each other to form the support body 10B. The first substrate 11A located at the center is a nonwoven fabric made of the above-mentioned glass fiber and secures mechanical strength and sufficient heat resistance. On the other hand, a pair of the second substrates 11B and 11C located outside the first substrate 11A are nonwoven fabrics formed of the above-mentioned resin fibers and has excellent printability with respect to a metal oxide ink. In the example illustrated in Fig. 10, since the first substrate 11A functions as a core material of the support body 10B, fibers which are slightly poor in heat resistance may be used as fibers constituting the second substrates 11B and 11C.

In the above-described example, a single sheet of nonwoven fabric is made of a single type of fiber, but the fabric is not particularly limited thereto. A single sheet of nonwoven fabric may be made of a plurality of types of fibers, or a single sheet of a nonwoven fabric may be made of fibers having different diameters. For example, although not specifically illustrated, the support body may be made of a single sheet of a nonwoven fabric containing both a glass fiber and a resin fiber.

Instead of a nonwoven fabric, a porous body such as a sponge may be used as a support body. This porous body has a large number of openings passing from the upper surface to the lower surface and can be formed by foaming an organic material such as a resin or a rubber.

Next, in step S20 of Fig. 7, the metal oxide ink 41 is applied to the upper surface 101 of the support body 10 as illustrated in Fig. 8(b). The metal oxide ink 41 in this embodiment corresponds to an example of the dispersed solution in the invention.

The metal oxide ink 41 is a solution containing metal oxide particles and a reducing agent. Specific examples of the metal oxide particles include nanoparticles such as a copper oxide (Cu₂O), a silver oxide (Ag₂O), a molybdenum oxide (MoO₂, MoO₃), or a tungsten oxide (WO₂, WO₃). As the reducing agent, a material containing carbon atoms functioning as reducing groups at the time of the reduction reaction of the metal oxide can be used, and for example, a hydrocarbon compound such as ethylene glycol may be exemplified. As the solvent contained in the solution of the metal oxide ink 41, for example, water or various types of organic solvents can be used. In addition, the metal oxide ink 41 may contain a polymer compound as a binder component or various types of regulating agents such as a surfactant. In a case where the metal oxide particles are silver oxide (Ag₂O), a reducing agent is unnecessary.

The metal oxide ink 41 may contain a plurality of types of metal oxide particles. In addition to the metal oxide particles, particles of a noble metal such as silver (Ag), platinum (Pt), gold (Au) or the like may be used. Alternatively, instead of the metal oxide particles, particles of a noble metal such as silver (Ag), platinum (Pt), gold (Au) or the like may be used. In this case, a reducing agent is unnecessary.

The method of applying the metal oxide ink 41 to the support body 10 is not particularly limited, but either a contact coating method or a non-contact coating method may be used. As specific examples of the contact coating method, screen printing, gravure printing, offset printing, gravure offset printing, flexographic printing, and the like may be exemplified. On the other hand, as specific examples of the non-contact coating method, inkjet printing, spray coating, dispensing coating, jet dispensing, and the like may be exemplified.

The number of times of applying the metal oxide ink 41 to the support body 10 is not particularly limited to one, and the metal oxide ink 41 may be applied to the upper surface 101 of the support body 10 plural times. The composition of the metal oxide ink 41 may be different for each application.

As illustrated in Fig. 8(c), the metal oxide ink 41 applied to the upper surface 101 of the support body 10 infiltrates (permeates) into the support body 10 through the openings 13 and the voids of the support body 10 to reach the lower surface 102 of the support body 10. As a result, an ink impregnated portion 42 is formed in the support body 10. In this case, since the support body 10 is configured by a nonwoven fabric made of the glass fibers 11 in this embodiment, the metal oxide ink 41 reaches the lower surface 102 without bleeding and spreading inside the support body 10 while keeping the planar shape (in this example, a planar shape having a linear portion and a pair of enlarged portions) at the time of the ink being applied to the upper surface 101 of the support body 10.

In contrast, in a case where a nonwoven fabric (for example, paper) made of vegetable fibers (pulp) is used as a support body, the metal oxide ink applied to the support body infiltrates into the vegetable fibers themselves constituting the support body. For this reason, the metal oxide ink bleeds and spreads through the vegetable fibers and spreads, so that the planar shape at the time of applying the ink to the upper surface of the support body cannot be kept. In contrast, in a case where a glass fiber or a resin fiber is used as fibers constituting the support body 10 as in this embodiment, the metal oxide ink 41 does not infiltrate into the fiber, so that the metal oxide ink 41 does not bleed and spread inside the support body 10.

In a case where a woven fabric is used as the support body, since the woven fabric has small openings and voids originally, the metal oxide ink can hardly infiltrate into the support body. In addition, even if the metal oxide ink infiltrates into the support body made of the woven fabric, the metal oxide ink bleeds and spreads along the regularly aligned fibers, and the planar shape at the time of applying the ink to the upper surface of the support body cannot be kept. On the other hand, in a case where a nonwoven fabric is used as the support body 10 as in this embodiment, the opening 13 and the voids are relatively large, so that the metal oxide ink 41 easily permeates into the support body 10. In addition, in a case where a nonwoven fabric is used as the support body 10, since the fibers are randomly aligned, the metal oxide ink does not bleed and spread along the fibers.

Next, in step S30 of Fig. 7, as illustrated in Fig. 8(d), the ink impregnated portion 42 is dried to remove the solvent, so that a metal oxide containing portion 43 is formed. More specifically, the ink impregnated portion 42 is dried at 100 to 120°C for about 20 to 120 minutes by a drying device. The metal oxide containing portion 43 in this embodiment corresponds to an example of the precursor in the invention. The metal oxide containing portion 43 is a layer containing the above-described metal oxide particles (copper oxide or the like).

For example, in a case where the support body 10 is relatively thick, as illustrated in Figs. 11(a) to 11(f), by applying metal oxide inks 41A and 41B from both sides of the support body 10, metal oxide containing portions 43A and 43B may be formed.

More specifically, first, the metal oxide ink 41A is applied to one main surface 101 of the support body 10 (Fig. 11(a)), an ink impregnated portion 42A is formed by allowing the metal oxide ink 41A to infiltrate into the center of the support body 10 (Fig. 11(b)), and the metal oxide containing portion 43A is formed by drying the ink impregnated portion 42A (Fig. 11(c)). Next, after turning the support body 10 upside down, the metal oxide ink 41B is applied to the other main surface 102 of the support body 10 (Fig. 11(d)), and an ink impregnated portion 42B in contact with the metal oxide containing portion 43A is formed by allowing the metal oxide ink 41B to infiltrate into the center of the support body 10 (Fig. 11(e)), and the metal oxide containing portion 43B is formed by drying the ink impregnated portion 42B (Fig. 11(f)). The metal oxide containing portions 43A and 43B formed in this manner pass from the upper surface 101 to the lower surface 102 of the support body 10.

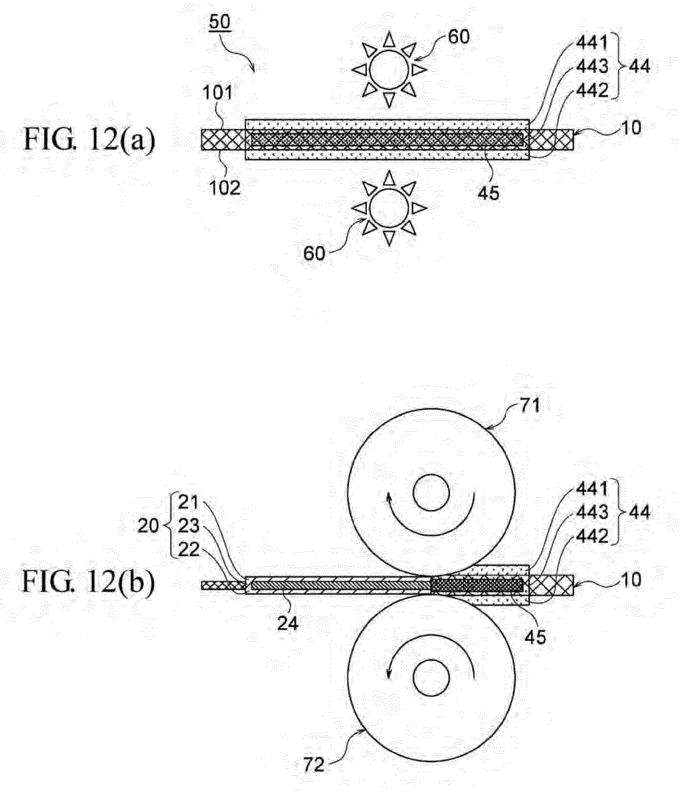

Returning to Fig. 7, after the metal oxide containing portion 43 is formed on the support body 10, in step S40, as illustrated in Fig. 12(a), pulsed light (pulsed electromagnetic wave) from the light sources 60 arranged on the upper and lower sides of the support body 10 is output to the metal oxide containing portion 43 of the support body 10. As a result, a reduction reaction and a metal sintering progress of the metal oxide particles are performed, so that a sintered body 44 is formed from the metal oxide containing portion 43. Since a carbon dioxide gas (or oxygen gas) or a vaporized gas of a solvent is released from the metal oxide containing portion 43 according to the reduction reaction, the sintered body 44 has a porous structure. The sintered body 44 is a layer containing a metal (copper or the like) obtained by reducing and sintering the above-mentioned metal oxide particles.

The light source 60 is not particularly limited, but as the light source, a xenon lamp, a mercury lamp, a metal hydride lamp, a chemical lamp, a carbon arc lamp, an infrared lamp, a laser irradiation device, and the like may be exemplified. As the wavelength component included in the pulsed light irradiated from the light source 60, visible light, ultraviolet light, infrared light, and the like may be exemplified. The wavelength component included in the pulsed light is not particularly limited as long as it is an electromagnetic wave, and for example, X-rays, microwaves, and the like may be included. The irradiation energy of the pulsed light irradiated from the light source 60 is, for example, about 6.0 to 9.0 J/cm², and the irradiation time of the pulsed light is about 2000 to 9000 µsec.

In this photo-sintering step S40, pulsed light from the light source 60 is directly supplied to the upper portion and the lower portion of the metal oxide containing portion 43, and pulsed light from the light source 60 is supplied to the side portion of the metal oxide containing portion 43 through the openings 13 or voids of the support body 10, and the reduction reaction and the metal sintering of the metal oxide particles are performed from the outer edge of the metal oxide containing portion 43. Therefore, propagation of light energy is hindered by the sintered body 44 previously formed on the upper portion, the lower portion, and the side portion of the metal oxide containing portion 43. Therefore, the pulsed light does not sufficiently reach the inside of the metal oxide containing portion 43, and the insulator 45 made of an unsintered metal oxide remains inside the sintered body 44.

As a result, the sintered body 44 has a first outer layer 441 formed on the upper surface 101 of the support body 10, a second outer layer 442 formed on the lower surface 102 of the support body 10, and an inner layer 443 formed inside the support body 10, and the entire circumference of the insulator 45 is covered with the sintered body 44. Although not specifically illustrated, the first outer layer 441 corresponds to the first outer layer 21 of the above-described conductor 20 and has the same planar shape as that of the first outer layer 21 (that is, a planar shape having a linear portion and a pair of enlarged portions). The second outer layer 442 corresponds to the second outer layer 22 of the conductor 20 described above and has substantially the same planar shape as the first outer layer 441. The inner layer 443 corresponds to the inner layer 23 of the conductor 20 described above and has a frame-like planar shape that is along the outer edge of the first outer layer 441 and along the outer edge of the second outer layer 442 and connects the first outer layer 441 and the second outer layer 442.

In a case where a substrate (for example, paper) made of vegetable fibers is used as the support body, there is a high risk that the fibers in contact with the inner layer of the sintered layer cannot withstand the thermal history during sintering and the fibers are broken due to carbonization. For this reason, a substrate made of vegetable fibers such as paper is not suitable for the support body in this manufacturing method.

In a case where the support body 10 is thin (for example, in a case where the thickness of the support body 10 before compression is 30 µm or less), in this photo-sintering step S40, the pulsed light reaches the inside of the metal oxide containing portion 43, and the entire metal oxide containing portion 43 is completely sintered. Therefore, in this case, although not specifically illustrated, since the metal oxide containing portion 43 does not remain in the sintered body 44, the inner layer having substantially the same solid planar shape as that of the first outer layer is formed. This inner layer corresponds to the inner layer 23B of the wiring board 1B illustrated in Figs. 5 and 6.

Next, in step S50 of Fig. 7, as illustrated in Fig. 12(b), the intermediate body 50 having the sintered body 44 is pass between a pair of compression rollers 71 and 72. Each of the compression rollers 71 and 72 is a cylindrical roller made of stainless steel or the like and has a smooth cylindrical pressing surface.

As the intermediate body 50 passes between the compression rollers 71 and 72, the sintered body 44 is compressed in the thickness direction, and the voids of the porous structure of the sintered body 44 are crushed. As a result, the sintered metal grain agglomerates of the sintered body 44 are brought into close contact with each other, and the conductor 20 having a low surface resistance value is formed. As one example, in a case where the surface resistance value of the sintered body 44 before compression is about 50 mΩ/m², the surface resistance value of the conductor 20 becomes about 5 mΩ/m² through this compression step S50. In this compression step S50, since the compression direction of the compression rollers 71 and 72 is the thickness direction of the support body 10, the voids between the fibers 11 of the support body 10 become small in the thickness direction. However, the openings 13 passing in the thickness direction do not become small.

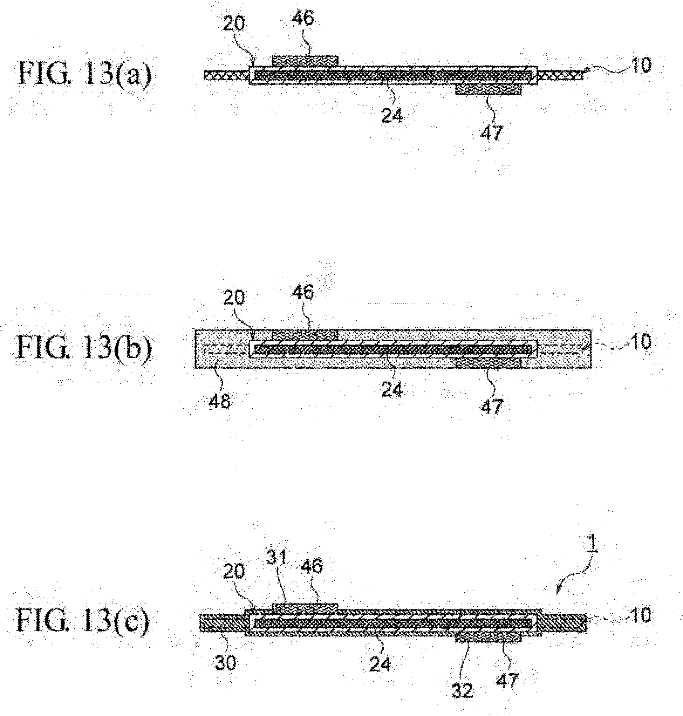

Next, in step S60 of Fig. 7, the liquid resin 48 is selectively applied to the support body 10 on which the conductor 20 is formed. More specifically, in this step S60, first, as illustrated in Fig. 13(a), a resist layer 46 is formed on one enlarged portion 212 (refer to Fig. 1) of the first outer layer 21 of the conductor 20, and a resist layer 47 is formed on the other enlarged portion of the second outer layer 22 of the conductor.

Next, in this step S60, the liquid resin 48 is applied to the entire portion of the support body 10 and the conductor 20. Therefore, as illustrated 13(b), the liquid resin 48 covers the surfaces of the first and second outer layers 21 and 22 of the conductor 20 and infiltrates (permeates) into the support body 10 through the openings 13 and voids of the support body 10.

Although not particularly limited, as specific examples of the liquid resin, a polymer emulsion obtained by dispersing a copolymer in water may be exemplified; and as specific examples of the copolymer, a copolymer obtained by copolymerizing acrylic acid ester or methacrylic acid as main constituents and an appropriate amount of styrene or acrylonitrile for imparting necessary properties may be exemplified. As a method of applying the liquid resin, the above-mentioned contact coating method or non-contact coating method may be exemplified.

Next, in step S70 of Fig. 7, as illustrated in Fig. 13(c), the insulating layer 30 is formed by curing the liquid resin 48 which covers the surface of the conductor 20 and is impregnated in the support body 10. Next, although not specifically illustrated, the resist layers 46 and 47 formed in step S60 are removed from the conductor 20, so that the wiring board 1 in this embodiment is completed.

As described above, in this embodiment, the metal oxide containing portion 43 is formed on the support body 10 so that the metal oxide containing portion 43 passes through the opening 13 from the upper surface 101 to the lower surface 102 of the support body 10. Therefore, the wiring board 1 having the same function as the double-sided exposed structure can be formed by using the photo-sintering process.

Steps S20 and S30 in Fig. 7 in this embodiment correspond to an example of the first step in the invention, step S40 in Fig. 7 in this embodiment corresponds to an example of the second step in the invention, step 50 in Fig. 7 in 7 in this embodiment corresponds to an example of the third step in the invention, the sintered body 44 in steps S40 and S50 in this embodiment corresponds to conductor in the second and third steps in the invention, and steps S60 and S70 in Fig. 7 in this embodiment correspond to an example of a fourth step in the invention.

The above-described embodiments are described the better understanding of the invention and are not described for limiting the invention. Therefore, each component disclosed in the above embodiments includes all design changes and equivalents belonging to the technical scope of the invention.

For example, in a case where the conductor 20 does not require excellent resistance characteristics, the intermediate body 50 (refer to Fig. 12A) before compression may be used as the wiring board. In this case, the sintered body 44 corresponds to an example of the conductor in the invention, the first outer layer 441 of the sintered body 44 corresponds to an example of the first outer layer in the invention, the second outer layer 442 of the sintered body 44 corresponds to an example of the second outer layer in the invention, the inner layer 443 of the sintered body 44 corresponds to an example of the inner layer in the invention, and the sintered body 44 in step S40 in this embodiment corresponds to an example of the conductor in the second step of the invention.

### EXPLANATIONS OF LETTERS OR NUMERALS

1, 1B ... wiring board
10, 10B ... support body
101 ... upper surface
102 ... lower surface
11A to 11C ... substrate
12 ... fiber
13 ... opening
20, 20B ... conductor
21 ... first outer layer
211 ... linear portion
212 ... enlarged portion
22 ... second outer layer
23, 23B ... inner layer
231 ... long side portion
232 ... rectangular portion
233 ... linear portion
234 ... enlarged portion
24 ... insulator
30 ... insulating layer
31 ... first window
32 ... second window
41, 41A, 41B ... metal oxide ink
42, 42A, 42B ... ink impregnated portion
43, 43A, 43B ... metal oxide containing portion
44 ... sintered body
441 ... first outer layer
442 ... second outer layer
443 ... inner layer
45 ... insulator
46, 47 ... resist layer
48 ... liquid resin
50 ... intermediate body
60 ... light source
71, 72 ...compression roller

## Claims

1. A wiring board comprising:
a support body which has a plurality of openings passing from one surface to other surface; and
a conductor which is supported by the support body, wherein
the conductor includes:
a first outer layer which is formed on one side of the support body;
a second outer layer which is formed on the other surface of the support body and has substantially the same shape as the first outer layer; and
an inner layer which is formed inside the support body and connects the first outer layer and the second outer layer, and
the inner layer has at least a frame shape which is along an outer edge of the first outer layer and along an outer edge of the second outer layer.

2. The wiring board according to claim 1, further comprising an insulator which is provided inside the frame-like inner layer and is made of a metal oxide.

3. The wiring board according to claim 1, wherein
the inner layer has substantially the same solid shape as the first outer layer.

4. The wiring board according to any one of claims 1 to 3, wherein
the support body includes a nonwoven fabric made of at least one of a glass fiber and a resin fiber.

5. The wiring board according to any one of claims 1 to 4, wherein
the support body is made of a plurality of types of substrates stacked on each other, and
the plurality of types of substrates include a plurality of types of nonwoven fabrics which are made of different types of fibers.

6. The wiring board according to any one of claims 1 to 5, further comprising an insulating layer which covers the conductor and infiltrates into the support body, wherein
the insulating layer includes:
a first window which exposes a portion of the first outer layer to an outside; and
a second window which exposes a portion of the second outer layer to an outside.

7. A method of manufacturing a wiring board, comprising:
a first step of supporting a precursor including at least one of metal particles and metal oxide particles on a support body; and
a second step of irradiating the precursor with a pulsed electromagnetic wave to form a conductor, wherein
the support body has a plurality of openings passing from one surface to other surface, and
the first step includes forming the precursor on the support body so that the precursor passes through the openings from one side to the other side of the support body.

8. The method according to claim 7, wherein
the first step includes applying a dispersed solution including at least one of metal particles and a metal oxide to only one side of the support body.

9. The method according to claim 7, wherein
the first step includes applying a dispersed solution including at least one of metal particles and a metal oxide to both surfaces of the support body.

10. The method according to any one of claims 7 to 9, further comprising a third step of compressing the conductor.

11. The method according to any one of claims 7 to 10, further comprising a fourth step of forming an insulating layer covering the conductor and infiltrating into the support body.
